# EUROPEAN PATENT APPLICATION

(11) **EP 0 628 990 A1**
(43) Date of publication of application: **14.12.1994**
(21) Application number: 93924821.7
(22) Date of filing: 12.11.1993
(51) Int. Cl.: H01L 21/22, H01L 21/205, H01L 21/324, H01L 21/00

(54) **HEAT TREATMENT APPARATUS**

(30) Priority: 13.11.1992 JP 327616/92
(71) Applicant: ASM JAPAN K.K., Tokyo 206 (JP)
(72) Inventor: KYOGOKU, Mitsusuke, Tama-shi, Tokyo 206 (JP); HONMA, Osamu, Tama-shi, Tokyo 206 (JP)
(74) Representative: de Bruijn, Leendert C.
(86) International application number: PCT/JP93/01661
(87) International publication number: WO 94/11899

(57) **Abstract**

Lowering of the airtightness of the reaction chamber of the appartus due to thermal degradation of the vacuum seal of the connection between the reaction chamber and a manifold is prevented, and particles produced from members of the apparatus due to the heating of the apparatus is prevented from contaminating the inside of the chamber. The wall of the reaction chamber is extended to the location sufficiently apart from the lower end of the heater around the reaction chamber. An exhaust port is provided in the wall to exhaust the reaction chamber.

## Description

### Technical Field

The present invention relates to a heat treatment apparatus which evacuates during flowing a predetermined reaction gas and processes objects with heat in maintaining a predetermined pressure.

### Background Art

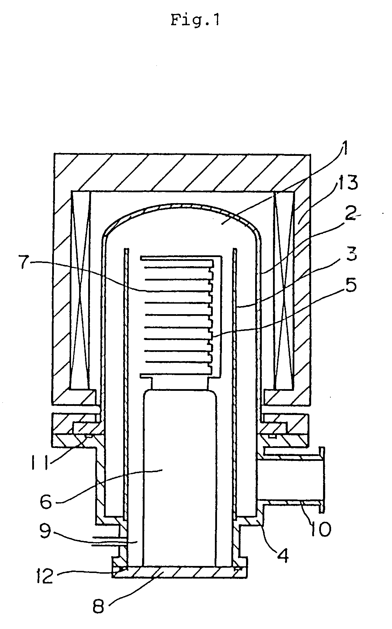

Fig.1 is a partial cross sectional view of a vertical type heat treatment apparatus in the art. A heat treatment apparatus has a wall 2 of a reaction chamber 1 made of a high purity material such as quartz and the like. The wall is formed as a cylindrical shape which is closed one end thereof, and the other end is opened and is connected to a manifold 4. The connection is sealed in vacuum by an O-ring and the like. Most of the wall 2 of the reaction chamber 1 is surrounded by a heater for heating the reaction chamber 1.

A compartment tube 3 is mounted on the manifold 4, and the compartment tube 3 has a length as reached on about the top of the reaction chamber 1. Also, in the manifold 4, an inlet 9 for introducing a reaction gas is provided below the compartment tube 3 and an outlet 10 for exhausting is provided above the position of connection of the compartment tube 3.

Inside the compartment tube, an object supporting boat 5 placing a plurality of objects 7 such as semiconductor wafers with a space between them in vertical and a boat table 6 for supporting the boat 5 are provided capable of loading into and unloading from the compartment tube. A treatment processed to the objects 7 is to form a thin film by a chemical vapor growth, and is annealing or the like. Below the manifold 4 a flange 8 for shielding an opening of the manifold and an elevator mechanism for moving the flange 8 in vertical are provided in an elevator chamber ( not shown in the figure ). The flange 8 can be elevated in vertical by a motion of the elevator mechanism, and the boat table 6 mounted on the flange 8 and the boat 5 are loaded into and unloaded from the wall 2 of the reaction chamber 1 thereby. When the flange 8 contacts to a shoulder formed under the manifold 4, the reaction chamber is sealed and is separated completely from the exterior environment.

The treatment is performed by introducing the reaction gas from the inlet 9 after containing the objects in the reaction chamber 1 and sealing it. The reaction gas goes upwardly through the inside of the compartment tube 3, and the gas goes downwardly through a space between an outer wall of the compartment tube 3 and an inner surface of the wall 2 of the reaction chamber 1 from an opening of the upper part of the compartment tube 3 after a predetermined reaction is done to the objects 7, and the gas is then exhausted from the outlet 10 provided in the manifold 4.

In the prior art as mentioned above, a vacuum seal member, such as an O-ring and the like, provided in the connection between the wall of the reaction chamber and the manifold is easily degraded. The degradation of the vacuum seal member causes particles in the reaction chamber to increase, and, for example, in the CVD apparatus the quality of CVD film is degraded thereby.

Moreover, metal molecules of stainless steel which is the constitutional material of the manifold are produced and spread from the manifold heated in high temperature, and the metal contamination to the objects is caused thereby. As a matter of course, the characteristic of a metal contaminated object is made considerably worse.

### Disclosure of the Invention

The present invention resolves two problems as mentioned above at the same time and provides high quality productions, and the objective of the present invention can be accomplished by locating the connection between the wall of the reaction chamber and the manifold apart from the heater by making the whole length of the reaction chamber longer and providing an outlet for exhausting the reaction gas in the wall of the reaction chamber.

### Brief Description of the Drawings

Fig.1 is a partial cross sectional view of a heat treatment apparatus in the prior art.

Fig.2 is a partial cross sectional view of a heat treatment apparatus in accordance with the present invention.

### Preferred Embodiment for carrying out the Invention

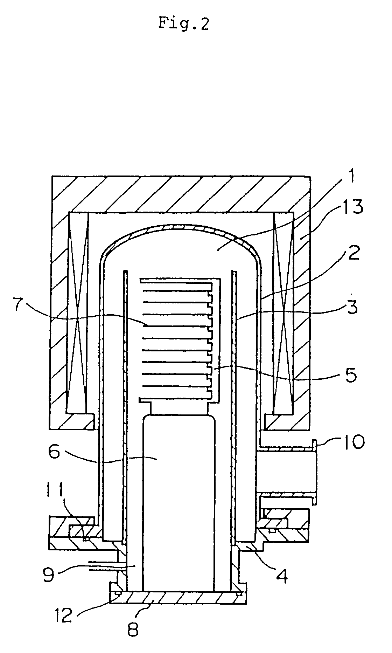

Referring to Fig. 2, an embodiment of the present invention is shown. A shoulder is provided in an opening of a cylinder shaped wall 2 of a reaction chamber 1, whose one end is closed, which is made of a high purity material such as quartz and the like, and the shoulder is connected to a shoulder of a manifold 4. A vacuum seal member such as an O-ring and the like is used in the connection to enhance the airtightness of the inside of the reaction chamber 1. A compartment tube 3 extended to about the top of the reaction chamber 1 is provided in the manifold 4. Moreover, an inlet 9 for introducing a reaction gas to the reaction chamber 1 is provided below the compartment tube.

Objects 7 are placed in an object supporting boat 5 provided on a boat table 6 with a space between the boats in vertical direction. A flange 8 is mounted on the lower end of the boat table 6, and the flange is connected to the lower end of the manifold during the heat treatment of the objects so that the reaction chamber 1 is sealed. At this time, the upper end of the object supporting boat 5 is positioned below the upper end of the compartment tube 3. a heater 13 is provided surrounding the wall 2 of the reaction chamber 1 on its outer side to accelerlate a reaction between the objects 7 and the reaction gas. In the wall 2 of the reaction chamber 1, an outlet 10 for exhausting the reaction gas is provided below the heater.

In the present invention, the reaction gas introduced from the inlet 9 goes upwardly to a position of the objects 7 through the inside of the compartment tube 3 and the objects are processed in a predetermined reaction with high temperature. The reaction gas goes out from an opening of the upper end of the compartment tube and goes downwardly between an outer wall of the compartment tube and an inner surface of the wall of the reaction chamber, and the gas is then exhausted from the outlet 10.

In an apparatus according to the present invention, a distance from the connection between the reaction chamber partition and the manifold to the heater is larger, and the thermal degradation of a vacuum seal member by the heater is sufficiently reduced.

Moreover, the surface temperature of the manifold is reduced, and the outlet is provided in the wall of the reaction chamber above the manifold so that the opportunity of exposing the manifold to the high temperature reaction gas is extremely small, and the metal contamination to the objects is considerably reduced thereby.

Therefore, the objective of the present invention is accomplished, and the objects maintained in the high quality is obtained thereby.

## Claims

1. A heat treatment apparatus, which is a part of a CVD apparatus and the like, comprising of: a wall of a reaction chamber made of a high purity material such as quartz and the like ; a heater for heating said reaction chamber formed by said wall, said heater positioning around said wall ; a manifold connected in an opening end of said wall ; and a flange shielding an opening of said manifold, wherein an outlet for exhausting the inside of said reaction chamber is provided in said wall.

2. A heat treatment apparatus according to claim 1, wherein said outlet is provided between said heater and said manifold.
